# EUROPÄISCHE PATENTSCHRIFT

(11) **EP 0 983 617 B1**
(45) Veröffentlichungstag und Bekanntmachung des Hinweises auf die Patenterteilung: **07.11.2001**
(21) Anmeldenummer: 98933463.6
(22) Anmeldetag: 06.05.1998
(51) Int. Cl.: H01P 3/08

(54) **VORRICHTUNG ZUM ÜBERTRAGEN VON HOCHFREQUENTEN SIGNALEN**
DEVICE FOR TRANSMITTING HIGH-FREQUENCY SIGNALS
DISPOSITIF POUR TRANSMETTRE DES SIGNAUX HAUTE FREQUENCE

(30) Priorität: 20.05.1997 DE 19721087
(43) Veröffentlichungstag der Anmeldung: 08.03.2000
(73) Patentinhaber: SIEMENS AKTIENGESELLSCHAFT, 80333 München (DE)
(72) Erfinder: BRAND, Uwe, D-81829 München (DE); TSCHERNITZ, Maximilian, D-85354 Freising (DE); STEINHAUSER, Karl-August, D-81545 München (DE)
(86) Internationale Anmeldenummer: DE9801262
(87) Internationale Veröffentlichungsnummer: WO9853520

(56) Entgegenhaltungen:
- EP-A- 0 309 982
- US-A- 5 418 504
- GARDIOL F E: "DESIGN AND LAYOUT OF MICROSTRIP STRUCTURES" IEE PROCEEDINGS H. MICROWAVES, ANTENNAS & PROPAGATION, Bd. 135, Nr. 3, PART H, Juni 1988, Seiten 145-157, XP000006243

## Beschreibung

Die Erfindung betrifft eine Vorrichtung gemäß dem Oberbegriff des Patentanspruchs 1.

Bei Kommunikationssystemen besteht zunehmend das Erfordernis, elektrische Signale mit sehr hoher Geschwindigkeit zu übertragen und zu verarbeiten. Die elektrischen Signale sind hier insbesondere als Steuersignale und/ oder Nachrichtensignale ausgebildet. Insbesondere bei Nachrichtensignalen, die nach einem asynchronen Transfermodus (ATM) übertragen werden, können beispielsweise Übertragungsraten von bis zu 830 MBit/s auftreten.Bei der Verarbeitung von derart hohen Übertragungsraten treten jedoch Probleme auf, die bei der Übertragung von Daten mit niedrigen Übertragungsraten nicht bekannt waren.

So besteht generell beim Übertragen von Signalen das Problem, daß elektrische Signale, die auf eng beieinanderliegenden Leitungen, die in der Regel als Kupferleitungen ausgebildet sind, gesendet werden, sich elektromagnetisch koppeln. Bei niederen Frequenzen erfolgt keine bzw. eine nicht ins Gewicht fallende elektromagnetische Koppelung der auf den Kupferleitungen verlaufenden Nachrichtensignale. Bei zunehmend hohen Übertragungsfrequenzen ist eine derartige Koppelung jedoch nicht mehr zu vermeiden. Koppelungen resultieren z.B. in elektromagnetischen Einstreuungen. Eine geeignete Abschirmung könnte zwar hier Abhilfe schaffen, jedoch wäre eine solche Vorgehensweise auf jeder Leitung innerhalb eines Kommunikationssystems unwirtschaftlich.

Um mögliche Koppelungen so gering wie möglich zu halten, wird daher eine komplementäre Übertragung der Nachrichtensignale über eine Datenleitung angestrebt. Diese ist dabei aus einem Leitungspaar ausgebildet.

Dies bedeutet, daß über eine der Leitungen des Leitungspaares eine Impulsfolge übertragen wird,während über die verbleibende Leitung des Leitungspaares die dazu komplementäre Impulsfolge übertragen wird. Damit verursacht ein mögliches Übersprechen von Signalen, die über benachbarte Leitungen übertragen werden, auf beiden Leitungen in gleicher Weise Störungen. Diese werden dann empfangsseitig unter Bildung des Differenzsignals wieder ausgemittelt. Insofern hat eine derartige Form der Datenübertragung eine relativ hohe Störsicherheit gegenüber möglicherweise auftretenden Störungen.

Die in den Kommunikationssystemen bislang verwendeten Baugruppen oder Leiterplatten weisen beim Stand der Technik Verbindungsstrukturen auf, wo Kupferbahnen parallel zu der Kante der jeweiligen Leiterplatte verlaufen (kantenparallel). Über diese Kupferbahnen werden dann die betreffenden elektrischen Signale gesendet.

Die verwendeten Leiterplatten sind aus einem Glasmatten aufweisenden Material gefertigt. Die Glasmatten selbst bestehen aus einzelnen Glasfaserbündeln, die in Harz getränkt und zu einer Webstruktur ausgebildet sind. An der Oberfläche einer derart ausgebildeten Glasmatte verlaufen dann Kupferbahenen, über die im praktischen Betrieb elektrische Signale geführt werden. Eine Glasmatte dient somit als Träger der Kupferbahnen. Um eine kompakte Bauweise zu erhalten,sind eine Mehrzahl dieser Glasmatten mit den zugehörigen Kupferleitungen zusammengeklebt.Dies bedeutet,daß die Mehrzahl dieser Kupferbahnen innerhalb des derart ausgebildeten "Lagenblockes" verläuft. Letzterer bildet dann die eigentliche Leiterplatte. Die Anschlüsse erfolgen oberflächenseitig durch Durchkontaktieren.

Bei sehr hohen Frequenzen, wie sie bei der Übertragung von ATM-Nachrichtensignalen verwendet werden, wird nun wie bereits angesprochen, eine komplementäre Übertragung der Nachrichtensignale über eine Datenleitung gesteuert. Die Dichte der Kupferleitungen innerhalb der Leiterplatte ist extrem hoch. Um die komplementäre Übertragung der Nachrichtensignale über eine Datenleitung platzsparend zu gestalten, wird - wie bereits vorstehend erwähnt - eine Datenleitung aus jeweils einem Kupferleitungspaar ausgebildet. Damit tritt ein durchaus erwünschtes elektromagnetisches Koppeln auf, da die Feldlinien beider Leitungen einander umfassen.

Hier besteht aber nun das Problem, daß die Struktur der Leiterbahnen in die Größenordnung der Webstruktur gelangt. Damit besteht beispielsweise die Möglichkeit, daß die eine Leitung des Paares in der Nähe einer Glasfaser sowie die verbleibende Leitung des jeweiligen Paares im Harz selbst verläuft. Beide Materialien haben jedoch unterschiedliche Dielektrizitätskonstanten. Da bei diesem Stand der Technik eine kantenparallele Führung der Kupferbahnen vorgesehen ist, bedeutet dies, daß die Kupferbahnen stets entweder in der Nähe einer Glasfaser oder im Harz selbst verlaufen können.

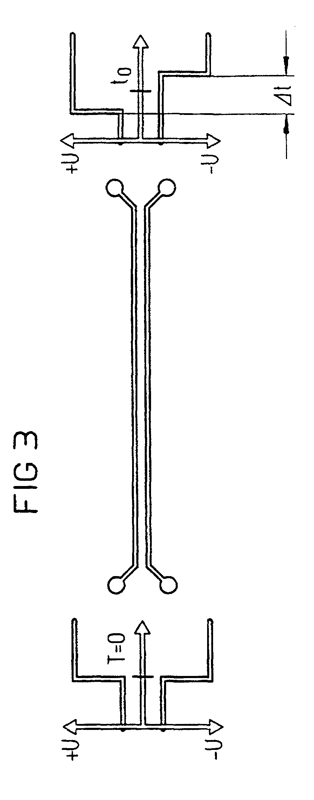

Daraus resultieren aber beim Übertragungsvorgang unterschiedliche Signallaufzeiten sowohl bei den beiden Kupferleitungen eines Paares, als auch zwischen den Datenleitungen. Die entsprechenden Verhältnisse sind zum besseren Verständnis in Fig. 3 aufgezeigt. Beispielsweise erhält der am Ende zweier Kupferleitungen eines Paares angeordnete, das Differenzsignal bildende Differenzverstärker die Flanken der komplementär übertragenden Impulse zu unterschiedlichen Zeitpunkten und erzeugt damit seinerseits eine gegebenenfalls flache Flanke bzw. Flankenverschiebung, die zum Triggern von weiteren Einrichtungen nicht mehr zu gebrauchen ist.

Eine Lösungsmöglichkeit dieses Problems besteht darin, homogene Materialien mit einer Dielektrizitätskonstanten zu verwenden. Diese sind jedoch zu teuer.

Der Erfindung liegt somit die Aufgabe zugrunde, einen Weg aufzuzeigen, wie Nachrichtensignale extrem hoher Frequenz über Kupferleitungen in Leiterplatten herkömmlicher Art übertragen werden können.

Aus der Druckschrift EP-A2-0309962 ist ein Substratmaterial und ein Verfahren für dessen Herstellung offenbart, daß das Problem der Laufzeitdifferenz löst, indem das mit dem Verfahren hergestellte substratmaterial aus mehreren Schichten besteht und die Faserbündel der einzelnen Schichten unter einem vorgegebenen Winkel zueinander angeordnet sind. Hierdurch entsteht somit eine Quasi-Isotropie. Allerdings sind dieser Druckschrift keine elektrische Signale führenden Datenleitungen sowie deren Anordnung in Bezug auf die Faserbündel entnehmbar. Dies ist deshalb auch nicht notwendig, weil durch die Quasi-Isotropie keinerlei Laufzeitdifferenzen zwischen den einzelnen Datenleitungen entstehen können.

Die Erfindung wird durch die Merkmale des kennzeichnenden Teils des Patentanspruchs 1 gelöst.

Vorteilhaft an der Erfindung ist insbesondere, daß die Datenleitungen nicht mehr kantenparallel im betreffenden Glasmattenmaterial geführt werden, sondern mit einem fest vorgegebenen definierten Winkel hierzu verdreht werden. Dies bedeutet letztendlich, daß die Datenleitungen nicht mehr ausschließlich auf einer Glasfaser bzw. im Harz geführt werden, sondern in gleicher Weise abwechselnd über Glas bzw. Harz verlaufen. Damit entsteht beim Übertragungsvorgang kein Unterschied in der Signallaufzeit. Herkömliche, kostengünstige Leiterplatten können somit auch für die Übertagung hochfrequenter Signale benutzt werden, was bei der Vielzahl der verwendeten Leiterplatten ein deutlicher Kostenvorteil ist.

Vorteilhafte Weiterbildungen der Erfindung sind in den Unteransprüchen angegeben.

Die Erfindung wird im folgenden anhand eines Ausführungsbeispiels näher erläutert.

Es zeigen:
- Figur 1: der konstruktive Aufbau einer Glasmatte,
- Figur 2: die Seitenansicht einer Glasmatte,
- Figur 3: der Signallauf beim Stand der Technik

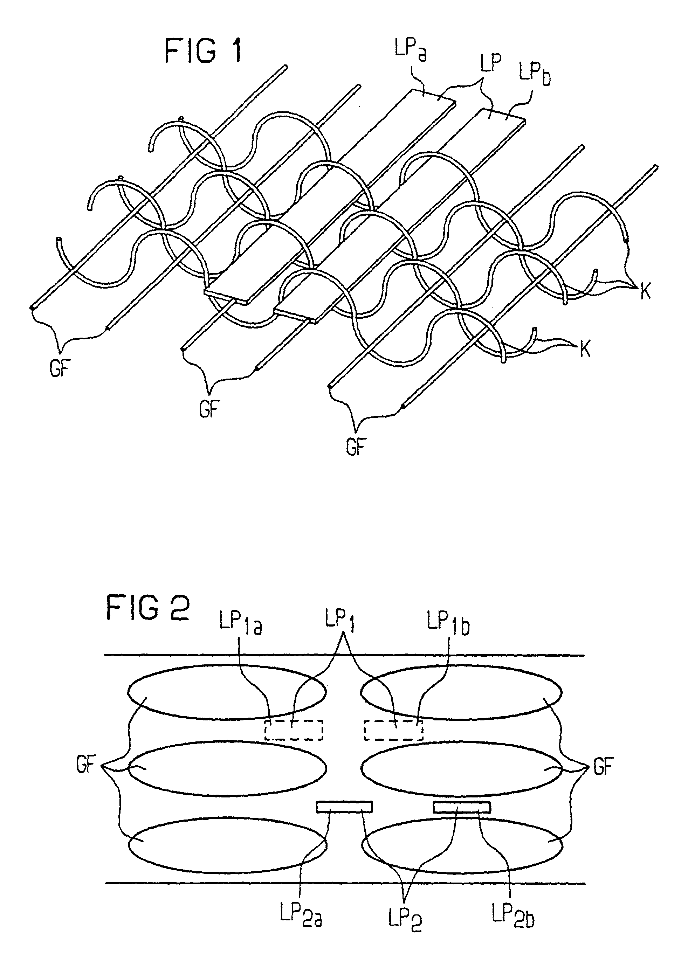

In Figur 1 ist der konstruktive Aufbau einer Glasmatte aufgezeigt. Demgemäß sind zunächst Glasfaserbündel GF aufgezeigt, die parallel zueinander angeordnet sind. Die Glasfaserbündel GF werden durch eine Mehrzahl von ebenfalls aus Glasfaserbündel bestehenden Ketten K verbunden und zusammengehalten. Gemäß Figur 1 werden die Ketten K mit "Phasenlagen" von 180° um die Glasfaserbündel GF gewebt. Insofern hat diese Art des Aufbaus durchaus Ähnlichkeit mit demjenigen von Textilien. Die quer zueinander angeordneten Ketten K und Glasfaserbündel GF sind jedoch nicht allein mechanisch fixiert, zusätzlich wird diese Vorrichtung noch in ein als Klebematerial verwendetes Harz getränkt, womit die Glasmatte eine quasi homogene Struktur erhält. In dieser Art des Aufbaus einer Glasmatte ist keinerlei Vorzugsrichtung bezüglich der Orthogonalität gegeben. Beide Hauptachsen sind gleichberechtigt.

Parallel zu den Glasfaserbündeln GF sind gemäß vorliegendem Ausführungsbeispiel die komplementären Signale führenden Datenleitungen LP angeordnet. Diese weisen jeweils zwei Kupferleitungspaare LPₐ, LP_{b} auf. Die paarweise Ausbildung der Datenleitungen ist jedoch nicht zwingend erforderlich. Vielmehr kann eine komplementäre Übertragung elektrischer Signale auch über lediglich eine Datenleitung erfolgen.

Figur 2 zeigt eine Seitenansicht der soeben beschriebenen Glasfasermatte gemäß Figur 1. Darin sind wiederum die Glasfaserbündel GF aufgezeigt, die in paralleler Form geführt werden und damit die Kanten der Glasmatte bzw. der Leiterplatte definieren. Weiterhin sind nun Datenleitungen LP₁ LP₂ aufgezeigt. Wesentlich daran ist, daß beide Datenleitungen als Alternativen zu betrachten sind und somit nicht beide zugleich in dieser Form in der Glasmatte angeordnet werden. Diesem Umstand wurde in Figur 2 durch die gestrichelte Darstellung Rechnung getragen. Die Datenleitung LP₁ bestehen aus den Kupferleitungspaaren LP₁ₐ sowie LP_{1b}. Die Datenleitung LP₂ wird in gleicher Weise durch ein Kupferleitungspaar LP₂ₐ sowie LP_{2b} gebildet.

Würden alle Datenleitungen der Glasfasermatte in ähnlicher Weise geführt wie die Datenleitung LP₁, so würde am Ende eines Datenleitungspaares kein Unterschied in der Signallaufzeit erkennbar sein. Dies liegt daran, daß die Datenleitung LP₁ quasi symmetrisch in die Glasmatte eingebunden ist und somit in gleicher Weise von den Dielektrika von Glas und Harz umfaßt wird. Unterschiede in der Signallaufzeit zu über eine andere Datenleitung übertragenen Signalen sind davon unberührt und nach wie vor gegeben.

Probleme entstehen jedoch jedoch bei der Führung der Datenleitung LP₂. Hier wird die eine Leitung des Kupferleitungspaares LP_{2b} in der Nähe der Glasfasern geführt, die eine relativ hohe Dielektrizitätskonstante aufweisen (ξᵣ=6). Die verbleibende Kupferleitung dieses Kupferleitungspaares LP₂ₐ läuft jedoch vorwiegend durch Harz, das eine weitaus niedrigere Dielektrizitätskonstante aufweist (ξᵣ=3). Ohne geeignete Gegenmaßnahmen wird der in Figur 3 aufgezeigte Signallauf empfangsseitig dem - nicht aufgezeigten - Differenzverstärker zugeführt. Die Flanken der komplementär übertragenen Signale unterscheiden sich um eine Zeit Δt.

Erfindungsgemäß wird nun dafür Sorge getragen, daß die Datenleitungen unter einem vorgegebenen Winkel zu den Glasfaserbündel durch die Glasfasermatte geführt werden. Vorzugsweise soll dieser Winkel zwischen 0,5° sowie 1° liegen. Andere Ausprägungen dieses Winkels sind jedoch ebenso denkbar. Auf jeden Fall muß bei der Wahl des Winkels dafür Sorge getragen werden, daß die Datenleitungen nicht parallel zu den Glasfasern angeordnet wird.

## Patentansprüche

1. Vorrichtung zum Übertragen von hochfrequenten Signalen, mit wenigstens einer aus einer Mehrzahl von Glasfaserbündeln gebildeten Glasfasermatte, die oberflächenseitig eine Mehrzahl von elektrische Signale führenden Datenleitungen aufweist und die gegebenenfalls mit weiteren derart gebildeten Glasfasermatten zu einer Leiterplatte zusammengefaßt wird,
**dadurch gekennzeichnet,**
**daß** die elektrische Signale führenden Datenleitungen (LP₁, LP₂) unter einem vorgegebenen Winkel zu den Glasfaserbündeln (GF) angeordnet sind.

2. Vorrichtung nach Anspruch 1,
**dadurch gekennzeichnet,**
**daß** die Datenleitungen (LP₁, LP₂) als Paar von Leiterbahnen (LP₁ₐ, LP_{1b}; LP₂ₐ, LP_{2b}) ausbildbar sind.

3. Vorrichtung nach Anspruch 2,
**dadurch gekennzeichnet,**
**daß** über die Leiterbahnen eine komplementäre Übertragung der elektrischen Signale erfolgt.

## Revendications

1. Dispositif pour transmettre des signaux haute fréquence, comportant au moins un mat de fibres de verre qui est formé d'une pluralité de faisceaux de fibres de verre, qui comporte du côté de la face supérieure une pluralité de lignes de données guidant des signaux électriques et qui est rassemblé le cas échéant à d'autres mats de fibres de verre supplémentaires ainsi réalisés pour former une plaquette à circuit imprimé,
**caractérisé en ce que** les lignes (LP₁, LP₂) de données guidant des signaux électriques sont disposées en faisant un angle prescrit par rapport aux faisceaux (GF) de fibres de verre.

2. Dispositif suivant la revendication 1, **caractérisé en ce que** les lignes (LP₁, LP₂) de données peuvent être réalisées en couple de piste (LP₁ₐ, LP_{1b} ; LP₂ₐ, LP_{2b}) conductrices.

3. Dispositif suivant la revendication 2, **caractérisé en ce qu'**une transmission complémentaire des signaux électriques s'effectue par l'intermédiaire des pistes conductrices.

## Claims

1. Device for transmitting high-frequency signals, with a glass-fibre mat which is formed from a plurality of bundles of glass fibres, has on its surface a plurality of data lines carrying electric signals and, if appropriate, is combined with further glass-fibre mats formed in such a way, to form a printed-circuit board, **characterized in that** the data lines (LP₁, LP₂) carrying electric signals are arranged at a predetermined angle in relation to the bundles of glass fibres (GF).

2. Device according to Claim 1, **characterized in that** the data lines (LP₁, LP₂) can be formed as a pair of conductor tracks (LP₁ₐ, LP_{1b}; LP₂ₐ, LP_{2b}) .

3. Device according to Claim 2, **characterized in that** a complementary transmission of the electric signals takes place over the conductor tracks.
